# DEMANDE DE BREVET EUROPEEN

(11) **EP 0 716 063 A1**
(43) Date de publication de la demande: **12.06.1996**
(21) Numéro de dépôt: 95402736.3
(22) Date de dépôt: 05.12.1995
(51) Int. Cl.: C07B 61/02, G01R 33/24, C07D 209/44

(54) **Solution contenant un radical nitroxyde pour la magnétométrie par résonance magnétique nucléaire**

(30) Priorité: 07.12.1994 FR 9414705
(71) Demandeur: COMMISSARIAT A L'ENERGIE ATOMIQUE, F-75015 Paris Cédex 15 (FR)
(72) Inventeur: Bourbon, Carole, 38500 La Buisse (FR); Moussavi, Mehdi, F-38240 Meylan (FR)
(74) Mandataire: Des Termes, Monique

(57) **Abrégé**

L'invention concerne une solution contenant un radical nitroxyde pour la magnétométrie par résonance magnétique nucléaire. Cette solution est constituée par un radical nitroxvde de formule : 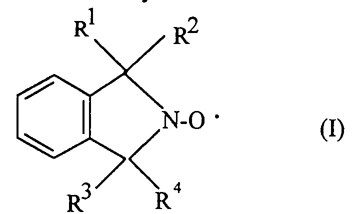
dans laquelle R¹, R², R³ et R⁴ qui peuvent être identiques ou différents, représentent un groupe alkyle ou un groupe alkoxy éventuellement deutérés, ou dans laquelle les couples R¹-R² et/ou R³-R⁴ forment ensemble un groupe cycloalkyle ou polycycloalkyle éventuellement deutéré, et N représente ¹⁴N ou ¹⁵N, dissous dans un solvant ayant un pouvoir oxydant et une viscosité appropriée.

Le solvant peut être constitué par un mélange d'eau et de deux composés jouant respectivement le rôle d'agent oxydant et de modificateur de la viscosité, par exemple, d'eau, d'éthylène-glycol et de NalO₄, ou être constitué uniquement par un mélange d'eau et d'un agent oxydant susceptible de modifier la viscosité tel que l'acide acétique.

## Description

La présente invention a pour objet une solution de radical nitroxyde dans un solvant, utilisable dans un magnétomètre à résonance magnétique nucléaire (RMN).

Elle conceme en particulier la magnétométrie en champ magnétique faible, utilisant les techniques de RMN avec polarisation dynamique des noyaux d'un solvant.

On sait que dans les magnétomètres à champ terrestre utilisant la résonance magnétique des noyaux, le principal problème est celui de la polarisation, c'est-à-dire de l'orientation forcée des spins, ou moments cinétiques des noyaux, notamment des protons du solvant dans lequel le radical est dissous en proportion convenable.

Cette polarisation peut être obtenue, conformément au document FR-A-1 174 136, par couplage de l'électron non apparié d'un radical libre dont la raie de résonance paramagnétique électronique est saturée par un champ de haute fréquence convenable, avec les noyaux du solvant.

Les magnétomètres à résonance magnétique nucléaire fonctionnant sur ce principe tels que ceux décrits dans FR-A-1 447 226 et FR-A-2 098 624, sont des magnétomètres très performants pour la mesure des champs magnétiques faibles.

Comme ils sont isotropes, c'est-à-dire qu'ils permettent de connaître directement la valeur du module du champ magnétique, indépendamment de la direction du capteur par rapport à celle du vecteur qu'ils mesurent, ils peuvent trouver des applications dans de nombreux domaines réclamant une haute sensibilité, tels que :
- la recherche d'épaves en mer, de pipelines,
- la cartographie magnétique de sites archéologiques,
- la surveillance de volcan,
- la stratigraphie magnétique en puits de forage, et
- le domaine militaire.

Ces magnétomètres à résonance magnétique nucléaire à couplage de spin comprennent généralement une tête ou capteur dans laquelle des bobines sont associées à au moins un échantillon de matière à propriété gyromagnétique et reliées à l'entrée et à la sortie d'un amplificateur linéaire pour constituer une boucle dans laquelle on mesure la fréquence d'oscillation nucléaire.

L'échantillon de matière à propriété gyromagnétique est constitué par une substance paramagnétique telle qu'un radical libre comportant un électron non apparié en solution dans un solvant comportant des noyaux atomiques à moment magnétique et moment cinétique non nuls.

Des solvants utilisables sont par exemple des alcools et des éthers tels que le méthanol, l'octanol, l'éthylène glycol et le dimethoxy éthane.

Des radicaux libres utilisables sont décrits par exemple dans EP-A-0 185 825, FR-A-2 063 416 et US-A-3 966 409. Parmi ceux-ci, on utilise en particulier les composés du EP-A-0 185 825, qui répondent aux formules suivantes : 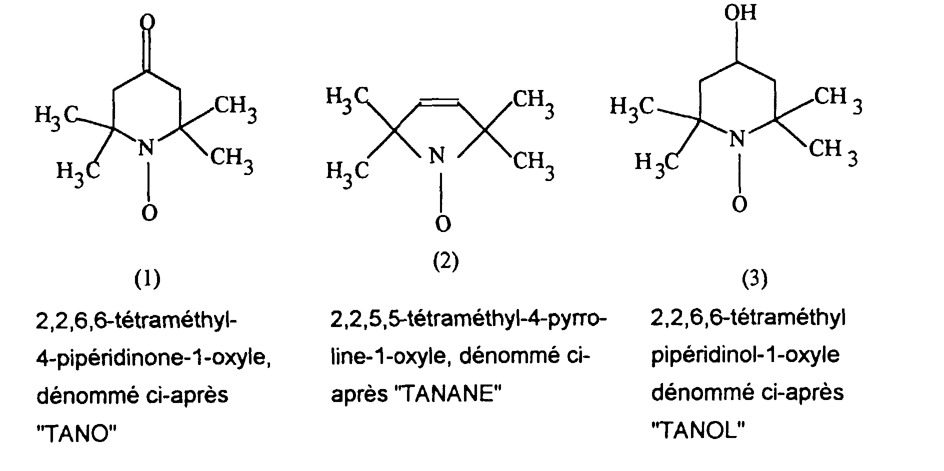 dans lesquelles les atomes d'hydrogène peuvent être totalement ou partiellement remplacés par des atomes de deutérium, et l'azote peut être de l'azote 14 ou de l'azote 15.

Jusqu'à présent, les meilleurs résultats pour la magnétométrie ont été obtenus avec les radicaux TANO 15D, soit le TANO décrit ci-dessus complètement deutéré avec ¹⁵N, et le TANANE 15, soit le TANANE décrit ci-dessus avec ¹⁵N.

Cependant, ces radicaux libres ne conviennent pas complètement dans le domaine de la prospection pétrolière qui impose aux capteurs un fonctionnement optimum à des températures de plus en plus élevées. En effet, avec un gradient géothermique moyen de 2°C/100m, les températures de fond de puits peuvent atteindre 150°C voire 200°C, selon la nature du sol et la proximité des sources chaudes, et les radicaux nitroxydes précités ne résistent pas à ces températures car ils ont une durée de vie limitée au delà de 70°C.

En effet, en milieu protoné, sous l'effet de la chaleur, le TANANE se transforme de la façon suivante : 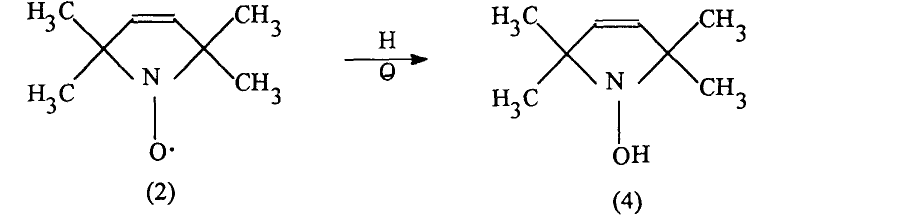 Aux températures élevées atteintes en fond de puits, il se produit donc une disparition progressive et irréversible du radical nitroxyde qui est converti en hydroxylamine.

Ainsi à 150°C, une solution de TANANE à une concentration de 10⁻³ mol/l dans de l'eau contenant à 5% de 2-méthoxy éthyl éther perd 20% de signal après 40 heures à cette température, et 50% après 300 heures à cette température.

A 180°C, la disparition du radical est encore plus significative : 20% de signal en moins après 20 heures à cette température, et 50% après 50 heures à cette température.

Une mesure en forage durant quelques heures, des sondes inutilisables après 20 à 30 heures à 180°C n'ont donc plus aucun intérêt.

Le document EP-A-423 033 propose l'utilisation de radicaux nitroxydes et de solvants présentant une meilleure stabilité à chaud que le TANANE mais cette stabilité ne dépasse pas une température de 130°C qui reste insuffisante comme on l'a vu plus haut.

La présente invention a précisément pour objet une solution contenant un radical nitroxyde, qui est utilisable pour la magnétométrie par résonance magnétique nucléaire à des températures élevées pouvant atteindre 200°C, pendant des périodes prolongées.

Selon l'invention la solution contenant un radical nitroxyde caractérisée en ce qu'elle est constituée par un radical nitroxyde de formule : 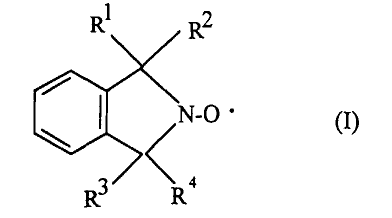 dans laquelle R¹, R², R³ et R⁴ qui peuvent être identiques ou différents, représentent un groupe alkyle ou un groupe alkoxy éventuellement deutérés, où dans laquelle les couples R¹-R² et/ou R³-R⁴ forment ensemble un groupe cycloalkyle ou polycycloalkyle éventuellement deutérés, et N représente ¹⁴N ou ¹⁵N,
dissous dans un solvant constitué par un mélange d'eau et d'au moins un composé, le ou les composés étant choisis de façon telle que la solution comprenne un agent oxydant de la forme réduite du radical nitroxyde et ait une viscosité appropriée pour la magnétométrie à des températures allant de 20 à 200°C.

Selon l'invention les groupes R¹, R², R³ et R⁴ peuvent être des groupes alkyle ou alkoxy, ou former ensemble des groupes cycloalkyle ou polycycloalkyle. Les groupes alkyle ou alkoxy utilisables peuvent être des groupes linéaires ou ramifiés, ayant généralement de 1 à 5 atomes de carbone, dont tout ou partie des atomes d'hydrogène peuvent être remplacés par des atomes de deutérium D.

Lorsque R¹-R² et/ou R³-R⁴ forment ensemble un groupe cycloalkyle, celui-ci a de préférence 4 à 11 atomes de carbone. Lorsque ces groupes forment ensemble un groupe polycycloalkyle, il peut s'agir de radicaux adamantyle. De préférence R¹, R², R³ et R⁴ sont des groupes alkyle inférieurs de 1 à 4 atomes de carbone, en particulier des groupes méthyle.

Dans ce radical nitroxyde, l'atome d'azote peut être ¹⁴N ou ¹⁵N. On préfère utiliser ¹⁵N. De même, on préfère utiliser des groupes alkyle ou alkoxy deutérés pour R¹, R², R³ et R⁴.

A titre d'exemple de radical nitroxyde approprié, on peut citer ceux qui répondent aux formules :

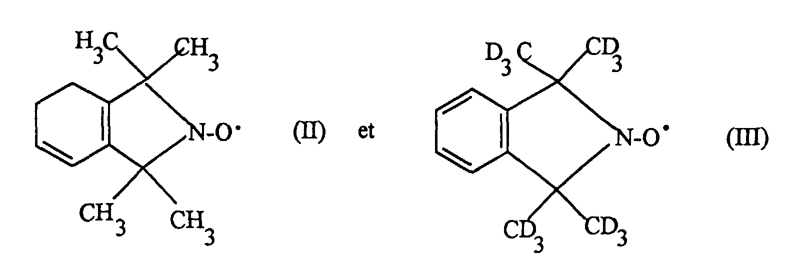

Conformément à l'invention, l'utilisation d'un radical nitroxyde répondant aux formules (II et III) données ci-dessus, permet d'obtenir une stabilité améliorée de la solution par rapport à ce que l'on obtient avec le radical du type TANANE.

En effet, le fait d'ajouter au radical nitroxyde du type 2,2,5,5,-tétraméthyl-pyrrolidine-1-oxyle un cycle à 6 atomes de carbone, constitué par un cycle benzénique, permet d'augmenter le volume de la molécule, de la rigidifier pour en faire une molécule plane et d'augmenter sa stabilité. Ainsi, en solution dans l'eau à une concentration de 10⁻³ mol/l, le radical nitroxyde de formule : 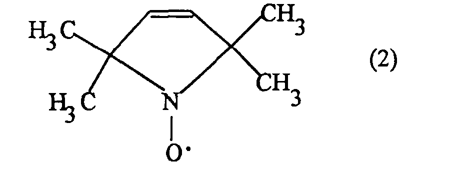 présente une durée de demi-vie de 250 heures à 150°C alors que le radical nitroxyde de formule (II) utilisé dans l'invention présente à cette même température une durée de demi-vie largement supérieure à 250 heures puisque la perte de signal n'est que de 10% au bout de 300 heures.

On précise que la durée de 1/2 vie d'un radical nitroxyde correspond au temps écoulé entre le moment où l'on porte le radical à la température voulue et le moment où le signal RPE de ce radical a perdu 50% de sa valeur initiale.

Selon l'invention, le solvant utilisé dans la solution joue un rôle important car il permet, d'une part, d'avoir une viscosité appropriée à la température de mesure dans le magnétomètre et, d'autre part, de stabiliser le radical nitroxyde en évitant sa conversion en hydroxylamine grâce à la présence d'un agent oxydant.

Pour obtenir ce résultat, le solvant est constitué d'eau à laquelle on ajoute un ou plusieurs composés capables de remplir ces différentes fonctions.

Selon un premier mode de réalisation de l'invention, on ajoute à l'eau deux composés dont l'un est un agent oxydant et l'autre est un composé organique compatible avec le radical nitroxyde, ayant une viscosité supérieure à celle de l'eau.

Ce composé organique peut être choisi parmi les alcools, les polyalcools et les éthers, en particulier ceux qui ont déjà été utilisés pour la fabrication des sondes RMN de magnétomètres.

Selon l'invention, le composé organique est de préférence l'éthylène glycol, et on l'utilise de préférence en quantité telle qu'il représente de 20 à 30% en volume du solvant.

Dans le mélange eau-éthylène glycol, l'eau joue un rôle déstabilisant en désorganisant les liaisons entre les molécules d'éthylène glycol, ce qui rend les atomes d'hydrogène beaucoup plus exposés et donc beaucoup plus réactifs avec le radical nitroxyde. De ce fait, on pourrait accélérer le processus de disparition de ce radical selon le schéma réactionnel suivant :

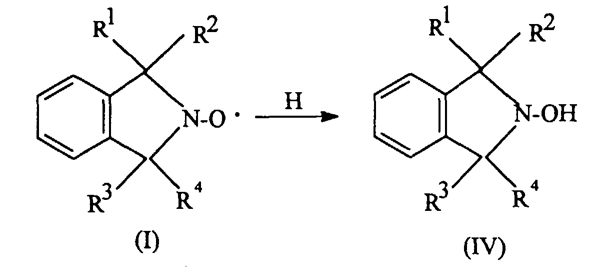

Conformément à l'invention, on remédie à cette situation, car la solution comprend de plus un agent oxydant afin de régénérer in situ le radical nitroxyde selon le schéma réactionnel suivant :

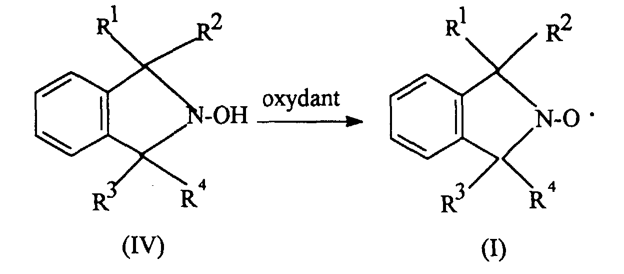

Les agents oxydants susceptibles d'être utilisés dans ce but peuvent être de différents types, mais on évite les agents trop réactifs à haute température puisque dans la sonde d'un magnétomètre, le volume n'est pas expansif.

Aussi, les agents oxydants connus pour la préparation de radicaux nitroxydes à partir d'hydroxylamine, tels que WO₅⁻, CH₃CN/H₂O₂ et l'acide m-chloroperbenzoïque ne conviennent pas car il sont trop réactifs.

A titre d'exemples, on peut utiliser des agents oxydants moins réactifs choisis parmi les métapériodates de métaux alcalins comme KlO₄ et NalO₄, et le bioxyde de plomb PbO₂.

Généralement, la solution comprend de 10⁻² à 5.10⁻² mol/l d'agent oxydant.

Selon un second mode préféré de réalisation de l'invention, on ajoute à l'eau formant en partie le solvant un seul composé capable de remplir les deux fonctions, c'est-à-dire un agent oxydant ayant une viscosité supérieure à celle de l'eau.

A titre d'exemple d'un tel composé, on peut citer l'acide acétique.

Lorsqu'on utilise l'acide acétique, celui-ci peut représenter 20 à 50% en volume du solvant

Dans la solution de radical nitroxyde de l'invention, la concentration en radical nitroxyde est choisie de façon à obtenir de bons résultats en magnétométrie

Généralement cette concentration se situe dans la gamme allant de 10⁻³ à 10⁻² mol/l.

Les radicaux nitroxyde de formule (I) utilisés dans l'invention peuvent être préparés par des procédés classiques. On peut utiliser en particulier le mode de synthèse décrit dans Aust. J. Chem. 1983, 36, p 397-401.

L'invention a également pour objet une sonde de magnétomètre à résonance magnétique nucléaire, sans axe interdit comprenant deux ensembles composés chacun d'une bobine entourant un récipient rempli d'un échantillon constitué par une solution contenant un radical nitroxyde, et deux cavités résonantes pour exciter les deux échantillons à deux fréquences distinctes, caractérisée en ce que les échantillons sont une solution d'un radical nitroxyde conforme à l'invention.

D'autres caractéristiques et avantages de l'invention apparaîtront mieux à la lecture de la description qui suit, donnée bien entendu à titre illustratif et non limitatif, en référence aux dessins annexés.

La figure 1, illustre les spectres de résonance paramagnétique électronique d'un radical nitroxyde utilisé dans l'invention, après plusieurs jours à 180°C en présence d'un agent oxydant constitué par NalO₄ (spectre 1) et sans agent oxydant (spectre 2).

La figure 2 est une courbe illustrant la stabilité d'une solution de radical nitroxyde conforme à l'invention en fonction du temps (en min).

La figure 3 illustre de façon schématique une sonde à résonance magnétique nucléaire conforme à l'invention.

Les exemples suivants illustrent les deux modes de réalisation d'une solution contenant un radical nitroxyde, conformes à l'invention.

Dans ces deux exemples, on utilise comme radical nitroxyde le radical de formule (III) dans laquelle N est ¹⁵N. Ce radical nitroxyde est obtenu en suivant le mode opératoire décrit dans Aust. J. Chem. 1983, 36 , pages 397-401, en utilisant de l'iodure de méthylmagnésium complètement deutéré.

### EXEMPLE 1.

Dans cet exemple qui correspond au premier mode de réalisation de l'invention, on utilise comme solvant un mélange d'eau et d'éthylène glycol comprenant 75% en volume d'eau et 25% en volume d'éthylène glycol, et on dissout dans cette solution 10⁻³ mol/l du radical nitroxyde de formule (III) et 10,6 g/l (5.10⁻² mol/l) de NalO₄.

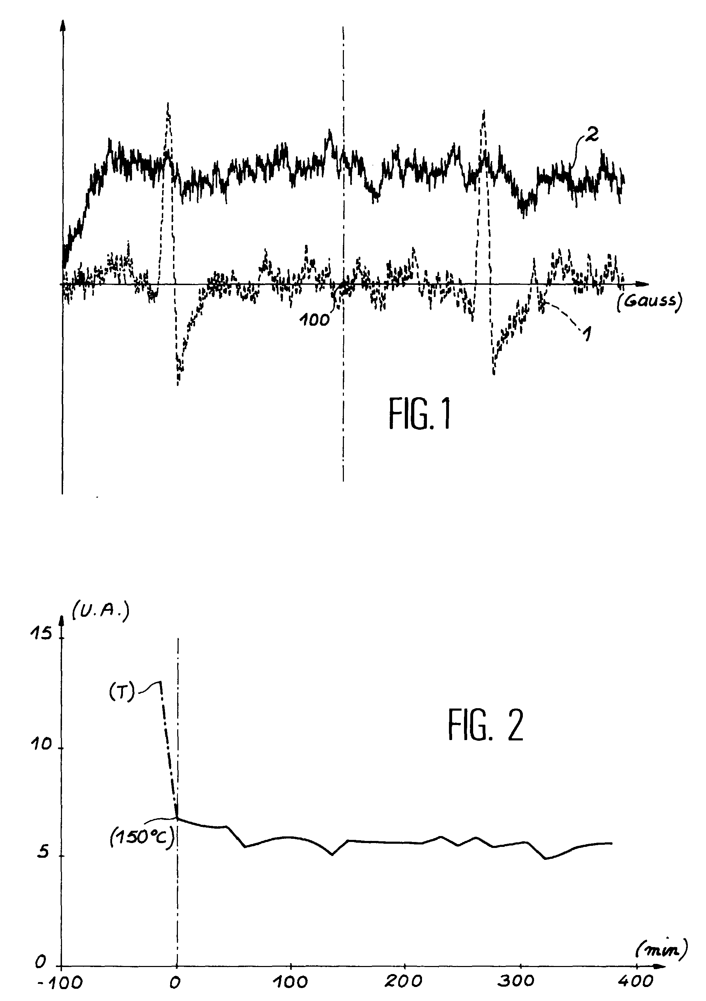

On porte cette solution à une température de 180°C pendant plusieurs jours, c'est-à-dire dans des conditions où le radical nitroxyde devrait être détruit, puis on détermine sur un spectromètre à résonance paramagnétique électronique RPE à 280 MHz, le spectre du radical nitroxyde. Le spectre obtenu est représenté sur la figure 1 (spectre 1).

Sur cette figure on a représenté également le spectre de la même solution, pris dans les mêmes conditions (180°C) mais sans addition de l'agent oxydant NalO₄ (spectre 2).

En comparant ces deux spectres, on remarque que seul le spectre 1 comporte les deux raies du radical nitroxyde. En revanche, le spectre 2 montre une destruction complète du signal dû au radical nitroxyde.

Ainsi, après un séjour de plusieurs jours à 180°C, la solution ne devrait plus contenir de radical nitroxyde mais conformément à l'invention, la présence d'un agent oxydant évite la détérioration du radical nitroxyde.

### EXEMPLE 2

Dans cet exemple qui correspond au second mode de réalisation de l'invention, on prépare une solution du radical nitroxyde de formule (III) à une concentration de 10⁻³ mol/l dans un mélange d'eau et d'acide acétique comprenant 50% en volume d'acide acétique. On détermine les propriétés de cette solution sur un spectromètre RPE à 9 GHz en portant la solution à 150°C et en déterminant le spectre périodiquement. Après la détermination de chaque spectre, on estime la concentration en radical nitroxyde par la méthode de double intégration du signal.

Les résultats obtenus sont représentés sur la figure 2 qui illustre l'évolution de cette concentration en radical nitroxyde (en unités arbitraires u.a) en fonction du temps (en minutes).

Sur cette figure le premier point qui est situé avant le temps 0 correspond au spectre déterminé à la température ambiante. Les autres points à partir du temps 0 correspondent à une température de 150°C.

Sur cette figure, on observe une diminution du signal lors de la montée en température depuis la température ambiante jusqu'à 150°C, mais le signal reste ensuite stable au cours du temps. En fin d'opération lorsqu'on remet la solution à la température ambiante et qu'on détermine son signal quelques heures plus tard, celui-ci a augmenté d'environ 15%.

On constate ainsi que la présence d'acide acétique qui joue le rôle d'agent oxydant, permet de stabiliser le signal du radical nitroxyde même pendant une durée prolongée, à une température de 150°C.

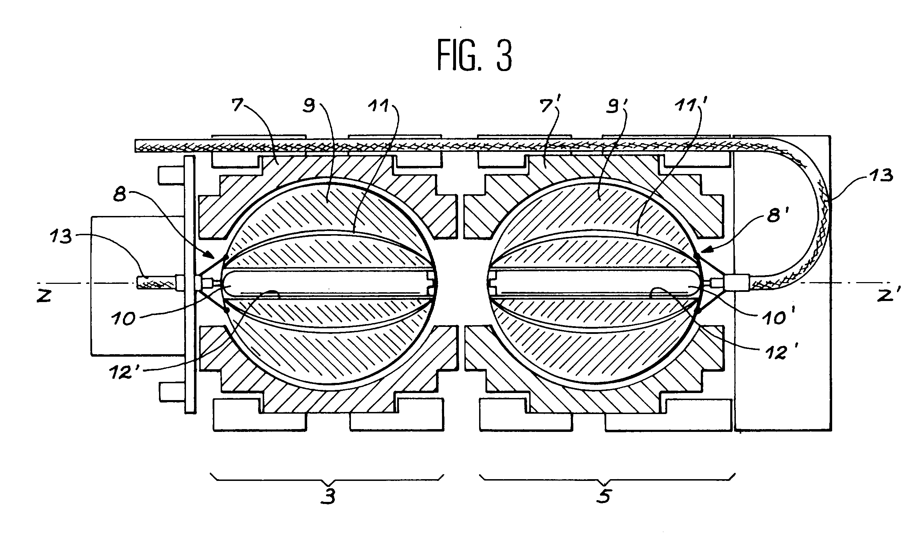

Sur la figure 3, on a représenté une coupe schématique d'une sonde d'un magnétomètre à résonance magnétique nucléaire, dans laquelle on peut utiliser la solution de l'invention. La sonde est constituée de deux ensembles similaires 3 et 5 alignés selon l'axe Z Z' ; chaque ensemble se compose d'une bobine 7 ou 7' entourant un premier échantillon 8 ou un second échantillon 8'. Les échantillons sont contenus dans deux récipients indépendants 10 et 10' constitués par des flacons sphériques symétriques dont les parois sont revêtues d'une peinture argentée selon des secteurs 9 et 9' séparés les uns des autres par des interruptions 11 et 11'. La cavité résonante d'excitation comprend deux cylindres argentés 12 et 12' reliés au conducteur initial d'un câble coaxial 13.

Dans cette sonde uniaxiale, les bobines 7 et 7' sont bobinées en sens contraire de sorte que les signaux parasites qui y sont induits, se compensent mutuellement ; au contraire les signaux utiles provenant des forces électromotrices créées par les phénomènes de résonance nucléaire s'ajoutent.

Le résultat ci-dessus n'est toutefois atteint que si la résultante macroscopique des moments magnétiques des noyaux du premier échantillon 8, est opposée à la résultante macroscopique des moments magnétiques des noyaux du second échantillon 8'. Dans le mode de réalisation illustré, comportant deux sources d'excitation à très haute fréquence, il faut que ces effets opposés interviennent en réponse à l'excitation qui s'effectue à une fréquence distincte pour les deux échantillons.

Cette sonde est très intéressante car elle permet d'effectuer des mesures de champs magnétiques à des températures aussi élevées que 180°C, sans destruction de la sonde.

## Revendications

1. Solution contenant un radical nitroxyde pour magnétométrie par résonance magnétique nucléaire, caractérisée en ce qu'elle est constituée par un radical nitroxyde de formule : 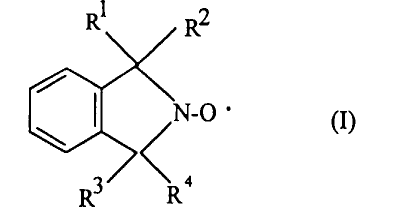 dans laquelle R¹, R², R³ et R⁴ qui peuvent être identiques ou différents, représentent un groupe alkyle ou un groupe alkoxy éventuellement deutérés, ou dans laquelle les couples R¹-R² et/ou R³-R⁴ forment ensemble un groupe cycloalkyle ou polycycloalkyle éventuellement deutéré, et N représente ¹⁴N ou ¹⁵N,
dissous dans un solvant constitué par un mélange d'eau et d'au moins un composé, le ou les composé(s) étant choisis de façon telle que la solution comprenne un agent oxydant de la forme réduite du radical nitroxyde et ait une viscosité appropriée pour la magnétométrie à des températures allant de 20 à 200°C.

2. Solution selon la revendication 1, caractérisée en ce que R¹, R², R³ et R⁴ représentent le groupe méthyle éventuellement deutéré.

3. Solution selon l'une quelconque des revendications 1 et 2 caractérisée en ce que N représente ¹⁵N.

4. Solution selon l'une quelconque des revendications 1 à 3, caractérisée en ce que le solvant est un mélange d'eau, d'un composé organique de viscosité supérieure à celle de l'eau et d'un agent oxydant.

5. Solution selon la revendication 4, caractérisée en ce que le composé organique est l'éthylène glycol.

6. Solution selon la revendication 5, caractérisée en ce que le solvant comprend 20 à 30% en volume d'éthylène glycol

7. Solution selon l'une quelconque des revendications 4 à 6 caractérisée en ce que l'agent oxydant est choisi parmi les métapériodates de métaux alcalins et le bioxyde de plomb.

8. Solution selon la revendication 7, caractérisée en ce que l'agent oxydant est le métaperiodate de sodium.

9. Solution selon l'une quelconque des revendications 4 à 8 caractérisée en ce qu'elle comprend 10⁻² à 5.10⁻² mol/l d'agent oxydant.

10. Solution selon l'une quelconque des revendications 1 à 3, caractérisée en ce que le solvant est un mélange d'eau et d'un agent oxydant ayant une viscosité supérieure à celle de l'eau.

11. Solution selon la revendication 10, caractérisée en ce que l'agent oxydant est l'acide acétique

12. Solution selon la revendication 11, caractérisée en ce que le solvant comprend 20 à 50 % en volume d'acide acétique.

13. Solution selon l'une quelconque des revendications 1 à 12, caractérisée en ce qu'elle comprend 10⁻³ à 10⁻² mol/l de radical nitroxyde.

14. Solution selon la revendication 1, caractérisée en ce qu'elle est constituée par le 1,1,3,3-tétraméthylisoindoline-2-yloxyl dissous à une concentration de 10⁻³ mol/l dans un mélange eau-acide acétique comprenant 50% en volume d'acide acétique.

15. Sonde de magnétomètre à résonance magnétique nucléaire sans axe interdit comprenant deux ensembles composés chacun d'une bobine entourant un récipient rempli d'un échantillon constitué par une solution contenant un radical nitroxyde, et deux cavités résonantes pour exciter les deux échantillons à deux fréquences distinctes, caractérisée en ce que les deux échantillons sont une solution d'un radical nitroxyde selon l'une quelconque des revendications 1 à 14.
